# EUROPEAN PATENT APPLICATION

(11) **EP 2 762 902 A2**
(43) Date of publication of application: **06.08.2014**
(21) Application number: 13193251.9
(22) Date of filing: 18.11.2013
(51) Int. Cl.: G01R 15/18

(54) **Current mutual inductor and current detection circuit of same**

(30) Priority: 31.01.2013 CN 201310039910
(71) Applicant: Siemens Aktiengesellschaft, 80333 München (DE)
(72) Inventor: Wu, Di, 200122 Shanghai (CN); Bao, Zhang Yao, 93049 Regensburg (DE); Lu, Xiang Dong, 201514 Shanghai (CN)

(57) **Abstract**

The present invention proposes a current mutual inductor for a magnetic modulation device, characterized by comprising: a magnetic core, comprising an amorphous alloy material; a winding encircling the magnetic core, for outputting a sensing signal; wherein the amorphous alloy material has a coercivity of less than 4 A/m under 1 kHz alternating current, and has a saturation magnetic induction strength of less than 1 T.

## Description

### Technical field

The present invention proposes a current mutual inductor for sensing alternating and direct current, based on magnetic modulation technology, and a current detection circuit including the current mutual inductor.

### Background art

The current mutual inductor is a common current sensing device, generally comprising a magnetic core and windings wound onto the magnetic core. The windings are divided into a primary winding and a secondary winding. The primary winding usually has a very small number of turns, and is connected in series in the circuit in which current is to be measured, so often has the entire current of the circuit flowing through it. The secondary winding has a higher number of turns and is connected in series in the measurement circuit, enabling detection to be carried out.

T. Sonoda et al., in the paper "An AC and DC Current sensor of high accuracy" published in IEEE in 1992 (T. Sonoda, R. Ueda, and K. Koga, IEEE Trans. On Industry Applications, vol. 28, no. 5, pp. 1087-1094, Sept.-Oct. 1992), proposed the use of a null method to measure the size of a current under measurement. The so-called null method involves balancing a drive current flowing through a mutual inductor with the current under measurement by means of negative feedback adjustment based on saturation time, so that the size of the current under measurement can be obtained on the basis of the size of the drive current. In this solution, T. Sonada et al. used a drive current with a triangular waveform, and in two identical circuits detected forward magnetic saturation and negative magnetic saturation, respectively. The magnetic saturation position detected was used to adjust the drive current so as to be balanced with the current under measurement.

Since only one positive and one negative feedback signal arise in each triangular wave excitation period in the solution of T. Sonoda et al., the drive current only has sufficient time to stabilize when the detection frequency is lower than the excitation frequency. Hence, owing to limitations on feedback speed, the solution can only detect currents with a frequency of at most a few hundred Hertz.

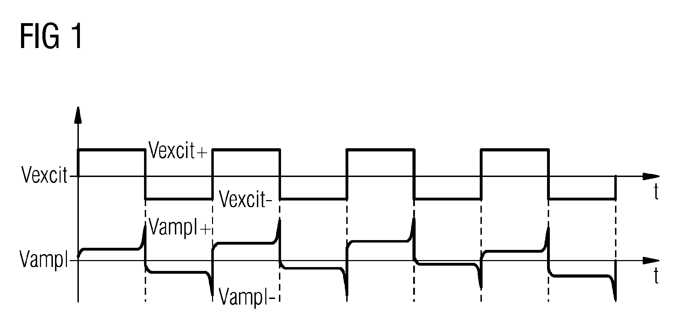

Patent EP1610133 describes a magnetic modulation solution based on current amplitude feedback. In this solution, oscillation of the current mutual inductor is maintained by flipping the excitation voltage (as shown by Vexcite in Fig. 1) when the current flowing through a coil of the mutual inductor reaches a certain threshold. In this solution, the current threshold at which flipping occurs is a fixed value, and the current flowing through the mutual inductor always oscillates within a fixed range. Under the influence of the current under measurement, fluctuation occurs in the linear region of oscillation, as shown by Vampl in Fig. 1. Before being outputted, Vampl must pass through a low-pass filter, to reduce the effect of the saturation region on the detection result while filtering out the frequency component of the excitation voltage. When the center voltage shift of Vampl increases, the signal-to-noise ratio of the entire system will fall, so the low-pass filter used to filter out the excitation frequency must have a steeper frequency response curve in order to keep the noise produced by excitation within an acceptable range. Once a low-pass filter with a steeper frequency response is adopted, the frequency detection range of the system will fall.

### Content of the invention

An objective of the present invention is to provide a current mutual inductor capable of having a wider detection range. Another objective of the present invention is to provide a current mutual inductor with a wide detection range and a low cost.

To achieve the above objects, the present invention proposes a current mutual inductor for a magnetic modulation device, characterized by comprising: a magnetic core, comprising an amorphous alloy material; a winding encircling the magnetic core, for outputting a sensing signal; wherein the amorphous alloy material has a coercivity of less than 4 A/m under 1 kHz alternating current, and has a saturation magnetic induction strength of less than 1 T. Preferably, the amorphous alloy material has a coercivity of less than 2 A/m under a 1 kHz alternating current. More preferably, the amorphous alloy material has a coercivity of less than 1 A/m under 1 kHz alternating current. Most preferably, the saturation magnetic induction strength of the amorphous alloy material is less than 0.5 T.

According to an embodiment of the present invention, the amorphous alloy material which may be used as the magnetic core of the current mutual inductor comprises: 67 wt% cobalt, 3 wt% nickel, 4 wt% iron, 2 wt% molybdenum, 12 wt% boron and 12 wt% silicon. In another embodiment, the amorphous alloy material which may be used as the magnetic core of the current mutual inductor comprises: 67 wt% cobalt, 3 wt% nickel, 4 wt% iron, 2 wt% molybdenum, 12 wt% boron and 12 wt% silicon. In another embodiment, the amorphous alloy material which may be used as the magnetic core of the current mutual inductor comprises: 66 wt% cobalt, 4 wt% iron and 30 wt% silicon, boron and molybdenum. In another embodiment, the amorphous alloy material which may be used as the magnetic core of the current mutual inductor comprises: 58 wt% cobalt, 10 wt% nickel, 5 wt% iron, and 27 wt% boron and silicon. In another embodiment, the amorphous alloy material contains more than 30 wt% nickel and more than 30 wt% iron.

In a preferred embodiment, the ratio of the square root of the cross-sectional area of the magnetic core to the length of the magnetic path of the magnetic core is less than 0.02.

According to another aspect of the present invention, the present invention proposes a current detection circuit, comprising: any one of the above current mutual inductors; and a drive circuit, for outputting a drive signal to the current mutual inductor; a sampling circuit, for detecting a current flowing through the current mutual inductor; a saturation detection circuit, for determining whether the current flowing through the current mutual inductor has reached saturation; and a polarity control circuit, which reverses the polarity of an excitation signal of the drive circuit in response to the saturation detection circuit detecting saturation.

Preferably, the sampling circuit comprises a sampling resistor connected in series with the winding of the current mutual inductor. More preferably, the saturation circuit determines whether the current mutual inductor has reached saturation by comparing a voltage drop across the sampling resistor with a threshold. Optionally, the saturation circuit determines whether the current mutual inductor has reached saturation by comparing a differential value of a voltage drop across the sampling resistor with a threshold.

More preferably, the drive signal outputted by the drive circuit to the current mutual inductor is essentially a constant voltage signal of a polarity which can be reversed alternately. Most preferably, a voltage drop across the sampling resistor is fed back to the drive circuit, and the drive circuit compensates for the voltage drop across the sampling resistor.

According to another aspect of the present invention, a current detector used for residual current detection is proposed.

### Description of the accompanying drawings

The accompanying drawings below are merely intended to illustrate and explain the present invention schematically, not to limit the scope thereof. In the drawings:
Fig. 1 shows the waveform of an excitation voltage Vexcite used to excite a current mutual inductor, and the waveform of a measurement voltage Vampl carrying information about a current under measurement;
Figs. 2A and 2B show hysteresis loops of an amorphous alloy and supermalloy, respectively, by way of example;
Fig. 3 shows a schematic diagram of a current detection device according to one embodiment of the present invention by way of example;
Fig. 4 shows a schematic diagram of a current detection device according to another embodiment of the present invention by way of example;
Fig. 5 shows a schematic diagram of a current detection device according to another embodiment of the present invention by way of example;
Fig. 6 shows a schematic diagram of a current detection device according to another embodiment of the present invention by way of example;
Figs. 7A and 7B show waveforms of an amorphous alloy material and permalloy, respectively.

### Particular embodiments

Particular embodiments of the present invention are now explained with reference to the accompanying drawings, to furnish a clearer understanding of the technical features, objects and effects thereof.

In the waveform diagram shown in Fig. 1, it has been found by the inventors of the present invention that the linear part of the excitation current waveform is by no means located in a central position, but deviates therefrom by a certain amount. Such a deviation is caused by the coercivity of the magnetic core material, with a larger coercivity giving rise to a larger deviation. Moreover, such a deviation occupies the dynamic range of the voltage, so that the current detection range of the entire system is limited. Thus the inventors of the present invention propose to search for a material with a lower coercivity to serve as the magnetic core material of the current mutual inductor.

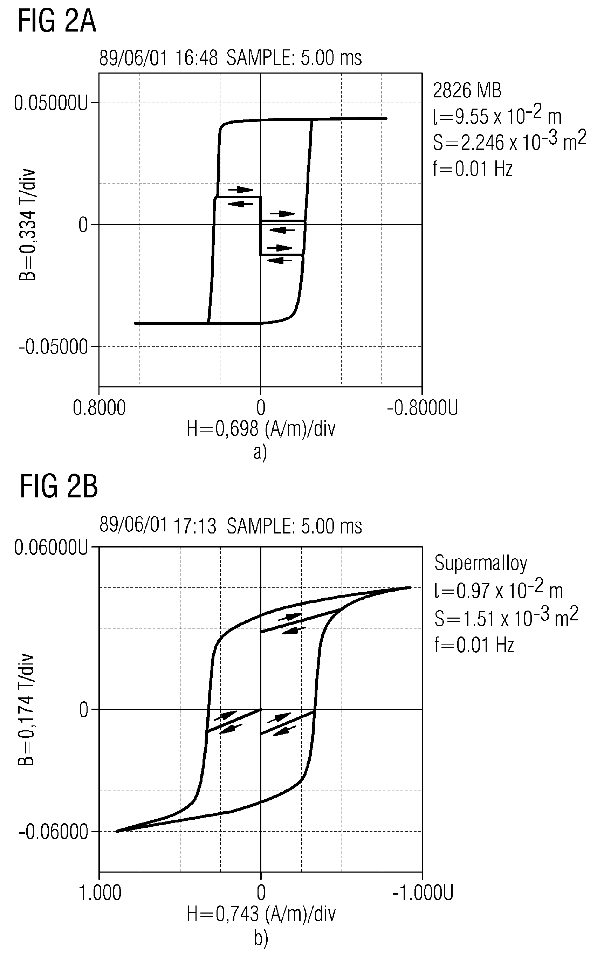

Figs. 2A and 2B show hysteresis loops, i.e. B-H curves, of an amorphous alloy and supermalloy, respectively. It can be seen from the drawing that the B-H curve of the amorphous alloy is steeper than the hysteresis curve of the supermalloy in Fig. 2B; in other words, the boundary between the linear region and the saturation region is clearer in the B-H curve of the amorphous alloy. Therefore if the amorphous alloy material is chosen as the magnetic core of the current mutual inductor, the amorphous alloy material will be able to respond more readily to excitation, and be more conducive to detection of a saturated state.

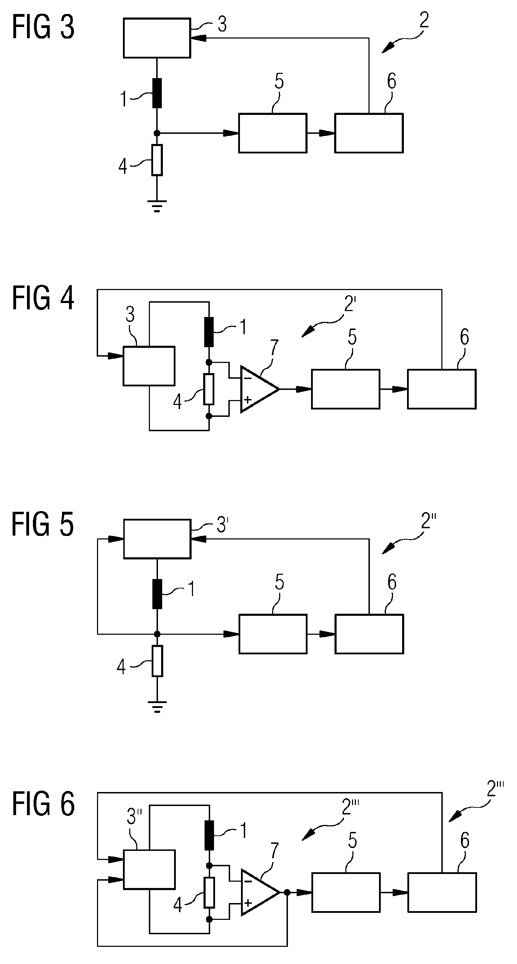

Fig. 3 shows a schematic diagram of a current detection device according to one embodiment of the present invention by way of example. As the figure shows, the current detection device 2 comprises: an inductance 1, a drive circuit 3, a sampling circuit 4, a saturation circuit 5, and a polarity control circuit 6. In Fig. 3, the current mutual inductor is represented by the inductor 1. Here, the inductor 1 is equivalent to a winding in the current mutual inductor, having one end connected to the drive circuit 3 and the other end connected to the sampling circuit 4. In the example shown in Fig. 3, the sampling circuit 4 is a sampling resistor connected in series with the inductor 1 (i.e. with the current mutual inductor), with the other end of the sampling resistor being connected to ground (GND). The saturation circuit 5 is connected to the sampling circuit 4, and used for determining whether the current mutual inductor has reached a saturated state according to the sampled value, and if it has, outputting a saturation indication signal to the polarity control circuit 6. In response to the saturation indication signal, the polarity control circuit 6 controls the drive circuit 3, such that the polarity of the drive signal thereof is reversed.

In the example shown in Fig. 3, the drive circuit 3 preferably outputs a drive signal of stable voltage, as shown by Vexcite in Fig. 1. The difference is that the triggering mechanism for reversal of drive signal polarity is no longer a fixed threshold, but rather the saturation operating point of the current mutual inductor.

To prevent the wide deviation shown by Vampl in Fig. 1 from occurring in the detected voltage signal, an amorphous alloy material with a lower coercivity is used as the magnetic core of the inductor 1 (i.e. the current mutual inductor) in Fig. 3. Here, "amorphous" means that no metallic bonding has occurred among the metal molecules to make the metal form crystals or grains. In most cases, amorphous alloy materials have a lower coercivity than most metal materials at low frequency. Thus in Fig. 3, an amorphous alloy with a low coercivity (e.g. lower than 2 A/m) is preferably used. The coercivity at low frequency of iron/nickel-based amorphous alloys, such as the alloy Fe₄₀Ni₃₈MO₄B₁₈, is generally 0.6 A/m to 1.2 A/m. More preferably, an amorphous alloy with a coercivity of less than 0.5 A/m is used. The coercivity at low frequency of cobalt-based amorphous alloys, such as Co₆₆Fe₄(Mo,Si,B)₃₀ and CO₅₈Ni₁₀Fe₅(Si,B)₂₇, is generally 0.2 A/m to 0.4 A/m. By comparison, the coercivity at low frequency of permalloys is higher, at 0.8 A/m to 6 A/m. In magnetic modulation systems, power consumption is affected to a certain extent by coercivity. The higher the coercivity, the more energy must be outputted by the system to overcome the coercivity. By using a magnetic material with a low coercivity, the excitation power consumption when the current under measurement is zero can be reduced effectively. Correspondingly, the magnitude of the shift in detection voltage Vampl when the current under measurement is non-zero is reduced. This reduces power consumption further, so that the dynamic range of the detection voltage is exploited fully.

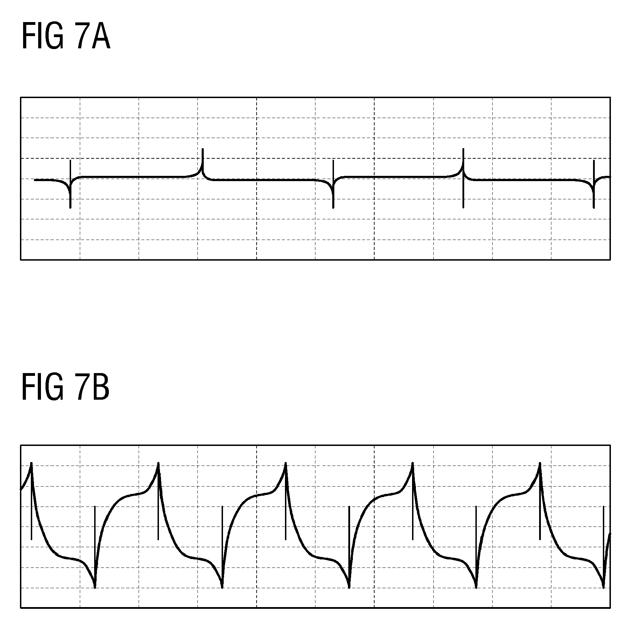

In addition, an amorphous alloy material can operate at frequencies of several hundred kHz. Other ordinary magnetic materials such as permalloys experience a rapid deterioration in magnetic performance as the operating frequency increases. In tests, the coercivity of one permalloy sample increased from 2 A/m at 100 Hz to 19 A/m at 2.5 kHz. The increase in coercivity of amorphous alloy materials is generally smaller. Thus by using an amorphous alloy material to make a magnetically modulated current mutual inductor, the frequency range can be expanded. Figs. 7A and 7B show waveforms of an amorphous alloy material and permalloy, respectively.

As shown in Fig. 2B, the amorphous alloy material easily reaches saturation, i.e. has a relatively low saturation strength. In the present invention, amorphous alloy materials with a saturation strength less than 1 T are preferred, to satisfy the requirement for fast switching between positive and negative saturation. For example, an iron-nickel alloy such as Fe₄₀Ni₃₈Mo₄B₁₈, with a saturation strength Bsat of about 0.75 T, can be used. More preferably, an amorphous alloy material with a saturation strength of less than 0.6 T is used. For example, a cobalt-based amorphous alloy such as Co₆₆Fe₄(Mo,Si,B)₃₀ or Co₅₈Ni₁₀Fe₅(Si,B)₂₇, with a saturation strength Bsat of about 0.55 T, can be used as the magnetic core. In most magnetic modulation techniques, the magnetic core repeatedly oscillates between the positive and negative saturation regions; in the linear regions, the current always increases or decreases in an approximately linear manner with time. If an easily saturated magnetic material as described above is used, the current mutual inductor will reach saturation in a shorter time and at a smaller current, so that the size of the excitation current decreases. Furthermore, the excitation frequency increases with the shortening of saturation time, so the detection circuit can filter out the excitation frequency from the current signal more easily. The low saturation magnetic induction strength of amorphous alloy materials can reduce the excitation power consumption and expand the frequency range.

In summary, amorphous alloy materials can have a very low saturation magnetization, and a very low coercivity at low frequencies and at relatively high frequencies. These properties mean that these materials not only enter a saturated state easily, but are also demagnetized very easily. Since the null method on which magnetic modulation technology is based requires that the magnetic fields created by the current under measurement and the excitation current are equal in magnitude, a detection error will arise if there is remanence in the iron core material. Therefore if an iron core has been exposed to a strong magnetic field, it must be demagnetized in order to eliminate the detection error caused by remanence. The ease with which amorphous alloy materials are demagnetized enables them to be demagnetized by excitation directly in most application scenarios, with no need to subject the mutual inductor to any special processing.

In addition, amorphous alloy materials have good ductility, so can be made into a form having a very small cross-sectional area. Thus in certain applications where there are restrictions on the cross section of the magnetic core, an amorphous alloy material can be used to make a magnetic core for which the ratio of the square root of cross-sectional area to the length of the magnetic path in the magnetic core is very small. In this way, the current detection range and frequency range can be increased significantly. By reducing this ratio to reduce the inductive reactance, the excitation frequency and detection frequency range can be increased, so that it becomes possible to expand the detection range by increasing the number of turns.

An iron/nickel-based amorphous alloy and cobalt-based amorphous alloys are listed above as examples. Further amorphous alloys which may be used in the present invention are listed below. One example of an amorphous alloy is cobalt-based as before, and may comprise 67 wt% cobalt, 3 wt% nickel, 4 wt% iron, 2 wt% molybdenum, 12 wt% boron and 12 wt% silicon. In another embodiment, the amorphous alloy material which may be used as the magnetic core of the current mutual inductor comprises: 67 wt% cobalt, 3 wt% nickel, 4 wt% iron, 2 wt% molybdenum, 12 wt% boron and 12 wt% silicon. In another embodiment, the amorphous alloy material which may be used as the magnetic core of the current mutual inductor comprises: 66 wt% cobalt, 4 wt% iron and 30 wt% silicon, boron and molybdenum (the combined content of silicon, boron and molybdenum is 30 wt%). In another embodiment, the amorphous alloy material which may be used as the magnetic core of the current mutual inductor comprises: 58 wt% cobalt, 10 wt% nickel, 5 wt% iron, and 27 wt% boron and silicon. Another example of an amorphous alloy is iron/nickel-based as before, and may comprise more than 30 wt% nickel and more than 30 wt% iron.

Figs. 4 to 6 show schematic diagrams of three different current detection devices, in which reference numbers which are the same as in Fig. 3 represent the same units as in Fig. 3. Their meanings will not be repeated here; only the differences will be discussed. In the current detection device 2' shown in Fig. 4, the voltage across the sampling resistor is processed by a differential amplifier 7 before being sent to the saturation circuit. In this way, the saturation circuit can acquire the voltage drop across the sampling resistor. Thus, even if the other end of the sampling resistor is also connected to another circuit, it will be able to detect whether the magnetic core has reached saturation more accurately. The current detection circuit 2" in Fig. 5 differs from Fig. 3 by having an additional feedback line. This feedback line acquires from the sampling resistor the voltage value at the upper end of the sampling resistor. Since the lower end of the sampling resistor is connected to ground, the aforesaid voltage value is just the voltage drop across the sampling resistor. The voltage drop across the sampling resistor is fed back to the drive circuit 3', which can compensate for this voltage drop and thereby ensure that the voltage applied to the current mutual inductor is essentially constant. The current detection device 2"' shown in Fig. 6 not only detects the voltage drop across the sampling resistor by means of the differential amplifier 7, but also feeds this precisely measured voltage drop back to the drive circuit 3", enabling the drive circuit to compensate for the voltage drop across the sampling resistor promptly.

It should be appreciated that although the present invention is described herein by way of embodiments, it is certainly not the case that each embodiment includes just one independent technical solution; such a mode of presentation is employed herein solely for the sake of clarity. Those skilled in the art should consider this Description in its entirety; the technical solutions in the various embodiments may be suitably combined to form other embodiments within the scope of understanding of those skilled in the art.

The above embodiments are merely particular, illustrative embodiments of the present invention, and are by no means intended to limit the scope thereof. Any equivalent variations, modifications or combinations made by those skilled in the art without departing from the concept and principles of the present invention should fall within the scope of protection thereof.

## Claims

1. A current mutual inductor for a magnetic modulation device, **characterized by** comprising:
a magnetic core, comprising an amorphous alloy material;
a winding encircling the magnetic core, for outputting a sensing signal;
wherein the amorphous alloy material has a coercivity of less than 4 A/m when driven by 1 kHz alternating current, and has a saturation magnetic induction strength of less than 1 T.

2. The current mutual inductor as claimed in claim 1, **characterized in that** the amorphous alloy material has a coercivity of less than 2 A/m when driven by a 1 kHz alternating current.

3. The current mutual inductor as claimed in claim 2, **characterized in that** the amorphous alloy material has a coercivity of less than 1 A/m when driven by a 1 kHz alternating current.

4. The current mutual inductor as claimed in claim 1, **characterized in that** the amorphous alloy material has a saturation magnetic induction strength of less than 0.6 T.

5. The current mutual inductor as claimed in claim 1, **characterized in that** the amorphous alloy material is a cobalt-based amorphous alloy.

6. The current mutual inductor as claimed in claim 5, **characterized in that** the amorphous alloy material comprises: 67 wt% cobalt, 3 wt% nickel, 4 wt% iron, 2 wt% molybdenum, 12 wt% boron and 12 wt% silicon.

7. The current mutual inductor as claimed in claim 5, **characterized in that** the amorphous alloy material comprises:
66 wt% cobalt, 4 wt% iron, and 30 wt% silicon, boron and molybdenum.

8. The current mutual inductor as claimed in claim 1, **characterized in that** the amorphous alloy material is an iron/nickel-based amorphous alloy.

9. The current mutual inductor as claimed in claim 8, **characterized in that** the amorphous alloy material comprises: 58 wt% cobalt, 10 wt% nickel, 5 wt% iron, and 27 wt% boron and silicon.

10. The current mutual inductor as claimed in claim 8, **characterized in that** the amorphous alloy material comprises more than 30 wt% nickel, and more than 30 wt% iron.

11. The current mutual inductor as claimed in any one of claims 1 to 10, **characterized in that** the ratio of the square root of the cross-sectional area of the magnetic core to the length of the magnetic path of the magnetic core is less than 0.02.

12. A current detection device, comprising:
the current mutual inductor (1) as claimed in any one of claims 1 - 11;
a drive circuit (3), for outputting a drive signal to the current mutual inductor (1);
a sampling circuit (4), for detecting a current flowing through the current mutual inductor (1);
a saturation detection circuit (5), for determining whether the current flowing through the current mutual inductor (1) has reached saturation; and
a polarity control circuit (6), which reverses the polarity of an excitation signal of the drive circuit in response to the saturation detection circuit (5) detecting saturation.

13. The current detection device as claimed in claim 12, wherein the sampling circuit (4) comprises a sampling resistor connected in series with the winding of the current mutual inductor.

14. The current detection device as claimed in claim 13, wherein the saturation circuit (5) determines whether the current mutual inductor has reached saturation by comparing a voltage drop across the sampling resistor with a threshold.

15. The current detection device as claimed in claim 13, wherein the saturation circuit determines whether the current mutual inductor has reached saturation by comparing a differential value of a voltage drop across the sampling resistor with a threshold.

16. The current detection device as claimed in claim 13, wherein the drive signal outputted by the drive circuit (3) to the current mutual inductor is essentially a constant voltage signal of a polarity which can be reversed alternately.

17. The current detection device as claimed in claim 16, wherein a voltage drop across the sampling resistor is fed back to the drive circuit (3'), and the drive circuit compensates for the voltage drop across the sampling resistor.

18. A residual current detection device, comprising:
the current detector as claimed in any one of claims 1 - 17.
